# EUROPEAN PATENT APPLICATION

(11) **EP 1 431 415 A1**
(43) Date of publication of application: **23.06.2004**
(21) Application number: 02800272.3
(22) Date of filing: 27.09.2002
(51) Int. Cl.: C23C 18/20, C08J 7/06

(54) **METHOD FOR PRODUCING METAL PLATED PLASTIC ARTICLE**

(30) Priority: 28.09.2001 JP 2001302868
(71) Applicant: Polyplastics Co Ltd, Tokyo 100-6006 (JP)
(72) Inventor: TAKAGI, Tatsuaki, Fuji-shi, Shizuoka 416-8533 (JP)
(74) Representative: Peel, James Peter
(86) International application number: PCT/JP2002/010073
(87) International publication number: WO 2003/029519

(57) **Abstract**

The invention provides a process for producing a plated plastic article, which requires no chemical etching and can ensure high quality of plating without addition of a large amount of any inorganic filler in order to form a physically rough surface for an effective plating adhesion. After molding thermoplastic materials having a shear strength of 50 MPa or more, the surfaces of the molded articles are subjected to liquid honing treatment with an aluminum abrasive so that the surface roughness Rz (average roughness of ten points) is 10 µm or more, and subsequently addition of catalyst, activation treatment, and electroless plating are carried out.

## Description

### FIELD OF THE INVENTION

The present invention relates to a process for producing a plated plastic article by plating the surface of a plastic molded article. More specifically, the present invention relates to a process for producing a plated plastic article in which the surface of a plastic article molded from a specific thermoplastic material is physically roughened by use of a specific method and specific conditions so as to obviate chemical etching.

### PRIOR ARTS

As a conventional technique of plating a plastic molded article, for example, a process comprising the steps of chemically etching the surface of the plastic molded article with a chemical such as a strong acid or a strong alkali, immersing the article in a palladium-tin colloid solution so as to add a catalyst, and depositing metal palladium on the surface of the molded article via activation treatment so as to plate the surface of the plastic molded article is well known and generally used. Further, as another process, an electroless plating process for a plastic molded article as disclosed in JP-A 2000-239422 in which the surface of an article molded from a specific thermoplastic resin composition is mechanically polished by air blasting so as to obviate chemical etching is known.

In the former process, usable plastic materials are significantly limited. That is, they are limited to only plastic materials which can be chemically etched by acid or alkali. A crystalline thermoplastic resin such as polyacetal, polybutylene terephthalate or polyphenylene sulfide is used in a wide variety of industrial fields, primarily in fields of electric and electronic equipment and automobiles, due to its excellent chemical resistance, heat resistance, electric properties, and mechanical properties. However, due to its excellent chemical resistance, the surface of an article molded from the crystalline thermoplastic resin is hardly etched with a chemical such as acid or alkali. Therefore, the crystalline thermoplastic resin is generally not suited for being plated. Thus, to plate the crystalline thermoplastic resin by the former process successfully, it is necessary to add a large amount of substance such as calcium carbonate which is easily eroded by a chemical such as sulfuric acid or hydrochloric acid at the time of compounding the material in advance and then carry out the chemical treatment. However, when a large amount of such a substance is added to the crystalline thermoplastic resin, there arises a problem that the excellent mechanical properties inherent in the crystalline thermoplastic resin are significantly degraded. Particularly, when the crystalline thermoplastic resin is used in mechanical parts requiring mechanical properties such as strength and tenacity, problems are liable to occur. Thus, its applications are significantly limited.

Even if it can be chemically etched and has no particular problems in terms of physical or chemical properties required for a product as a plastic material, since a chemical such as a strong acid or strong alkali is generally used in chemical etching, it is necessary to cope with, maintain, control and monitor the safety of these chemicals and an environment and equipment conforming to the chemicals appropriately and continuously during use of the chemicals and a process for preparing discharge of the chemicals. This has been an economically serious burden.

Meanwhile, since the latter process does not require pretreatment such as chemical etching, there is no need to add a large amount of substance which is liable to be eroded by a chemical such as sulfuric acid or hydrochloric acid, and it can be said to be an excellent process in that the properties inherent in the material can be maintained. Further, this process can also be said to be a technique conforming to the recent social trend with respect to global environment preservation in that it obviates use of a large amount of chemical substance such as a strong acid or strong alkali which places a significant burden on the environment. However, to form a plating layer which is practicable in actual use on a plastic molded article by the latter process, it is necessary to use a resin composition obtained by compounding a thermoplastic resin having specific performance with an inorganic filler whose amount is at least the same as that of the resin. When the amount of the inorganic filler is smaller than that of the resin, an acceptably roughed surface by air blasting is not formed easily, thereby lowering adhesion of plating. However, generally, an article molded from the resin composition obtained by adding a large amount of the inorganic filler to the thermoplastic resin has significantly low properties associated with mechanical tenacity such as elongation or impact strength. Therefore, as in the case of the former process, the latter process also has a problem that its applications are significantly limited.

### DISCLOSURE OF THE INVENTION

Thus, the present invention relates to a process for producing a plated plastic article. The process obviates chemical etching allowing for plating of a thermoplastic resin, i.e., pretreatment which requires use of a large amount of a chemical substance such as a strong acid or a strong alkali which places a significant burden on the environment. It does not necessarily require addition of a large amount of an inorganic filler for forming a physically roughened surface for an effective plating adhesion and therefore can produce a plated thermoplastic resin article which can be applied to a wide variety of industrial fields by taking advantage of various excellent properties inherent in the thermoplastic material; can be applied not only to a field of decoration but also to commercialization of components having electromagnetic wave shieldability and functions of electric circuits; provides excellent adhesion; and can secure high plating quality even in a severe environmental deterioration test such as a thermal shock cycle test.

Under the circumstances, the present inventor has made intensive studies and found that by molding a specific thermoplastic material, physically roughening the surface of the molded article by a specific process, and then carrying out addition of a catalyst, activation treatment and electroless plating in the order presented, a plated plastic product having excellent adhesion and having high plating quality even in a severe environmental deterioration test such as a thermal shock cycle test can be produced without impairing any properties of the thermoplastic material. The present invention has been completed by this finding.

That is, the present invention is a process for producing a plated plastic article which comprises the steps of molding a thermoplastic material having a shear strength of not lower than 50 MPa, liquid-honing the surface of the molded article with an alumina abrasive so as to attain a surface roughness Rz (average of roughnesses at 10 points) of not smaller than 10 pm, and then carrying out addition of a catalyst, activation treatment and electroless plating in the order presented.

### DETAILED DESCRIPTION OF THE INVENTION

Hereinafter, a specific constitution of the present invention will be described in detail. Firstly, a thermoplastic material used in the present invention will be described. The thermoplastic material used in the present invention has a shear strength of not lower than 50 MPa, preferably not lower than 55 MPa. The shear strength is measured at room temperature (air temperature of 23 ± 2°C) and a relative humidity of 50 ± 5% in accordance with ASTM D732.

Thus, the thermoplastic material used in the present invention has a shear strength value equal to or higher than a certain value. When the shear strength is lower than 50 MPa, sufficient adhesion (peel strength) of a plating layer to a plastic molded article cannot be obtained. It is considered that this indicates that a property evalution method such as peel strength or cross-cut tape peeling method which is generally practiced as a method for quantifying or qualifying adhesion of a plating layer is actually profoundly associated with the shear strength of a thermoplastic material. The plating layer is assumed to be adhered to the physically roughened surface of the plastic molded article due to a type of anchoring effect.

Specific examples of thermoplastic resins that can be used in the present invention include polycarbonate, a modified polyphenylene oxide, polyamide, polyacetal, polybutylene terephthalate, polyethylene terephthalate, polyphenylene sulfide, a liquid crystal polyester, polyimide, a syndiotactic polystyrene and polycyclohexane dimethylene terephthalate. More preferably, a thermoplastic material which contains, as a main component, at least one selected from the group consisting of polyacetal, polybutylene terephthalate, polyphenylene sulfide, polyamide, a liquid crystal polyester, polyimide and a syndiotactic polystyrene which can be molded easily to have excellent electric and mechanical properties is suitably used.

Of course, such a thermoplastic material may also be a material containing, in addition to the thermoplastic resin(s), a variety of conventionally known additives such as inorganic fillers, colorants, heat stabilizers, ultraviolet absorbers, molding assistants, flame retardants and flame retarding assistants as long as that does not deviate from the scope of the present invention. The thermoplastic material can be molded into a product of given shape easily by use of a given mold and resin melt-processing equipment such as an injection molding machine.

Next, a description will be given to liquid honing treatment which is carried out in the present invention after a plastic article is molded by use of the above thermoplastic material, for the purpose of physically roughening the surface of the plastic molded article. As a method for physically roughening the surface of a plastic molded article, a method of roughening the surface by sand paper which is the most simple method, and methods of mechanically applying a variety of abrasives to the surface of the molded article constantly, such as sand blasting (or air blasting), liquid honing, tumbling and shot blasting are well known. The method of roughening the surface by sand paper has problems that a roughened surface effective for adhesion of plating is difficult to form by the method and that the roughened surface lacks quality stability. The tumbling and shot blasting which primarily use iron powders or finely cut piano wires as abrasives has a problem that it takes time to obtain a surface of given roughness, indicating their lack of industrial mass-productivity. Meanwhile, the liquid honing treatment carried out in the present invention, which is also referred to as wet blasting, is a method in which water containing a particulate abrasive such as alumina is sprayed against the surface of an object to be treated by the force of compressed air so as to physically roughen the surface of the object. A liquid honing machine (wet blasting machine) is used in the liquid honing. A method of spraying a dried abrasive, without added water, against the surface of a plastic molded article by the force of compressed air is a method which is generally referred to as sand blasting or air blasting which differs from the liquid honing treatment. That is, since water is a spraying medium for the abrasive in the liquid honing, while air is the medium for the abrasive in the sand blasting or air blasting, the liquid honing undergoes a smaller pressure loss than the sand blasting and can roughen the surface of a plastic molded article efficiently since it exhibits a remarkable effect of cleaning the surface along with roughening of the surface. Further, while the sand blasting produces a large amount of dust, the liquid honing produces little dust. Thus, the liquid honing is highly safe in terms of working environment as well and is therefore suitably used as means for physically roughening a plastic molded article in the present invention. Further, the liquid honing used in the present invention is not limited to a particular form as long as water containing a particulate abrasive is sprayed against the surface of a plastic molded article to be treated by the force of compressed air. For example, the liquid honing may take a form in which the water is sprayed against each of plastic molded articles fixed to a jig successively or a form such as so-called barrel processing in which the water is sprayed against a number of plastic molded articles in a basket simultaneously.

Next, the abrasive used in the liquid honing treatment in the present invention will be described. Abrasives which are generally used in liquid honing treatment are broadly divided into plastic abrasives, glass abrasives and alumina abrasives according to materials constituting the abrasives. In the production process of the present invention, the target roughened surface cannot be easily obtained with the plastic abrasive or glass abrasive, and sufficient adhesion of the plating layer cannot be obtained accordingly. Meanwhile, the alumina abrasive is characterized by being a hard abrasive with sharp edges which maintains an abrasive effect regardless of proceeding of abrasion and being thermally, electrically and chemically inert. As results, the alumina abrasive hardly causes an adverse effect on a post-treatment step. Thus, the alumina abrasive can be suitably used since the desired roughened surface of plastic in the present invention can be obtained in a short time with the alumina abrasive.

Further, to physically roughen the surface of a plastic molded article by the liquid honing by use of the alumina abrasive in the present invention, the surface of the plastic molded article is roughened so that the surface has a surface roughness Rz (average of roughnesses at 10 points) of not smaller than 10 µm, particularly preferably not smaller than 15 µm. Further, an upper limit to the surface roughness Rz is not particularly limited but is around 70 µm. When the surface is roughened beyond the upper limit value, the effect is saturated, and the appearance of the surface may deteriorate. Meanwhile, when the surface roughness Rz (average of roughnesses at 10 points) is smaller than 10 µm, sufficient anchors cannot be formed, so that there arises a problem that practically sufficient adhesion of a plating layer cannot be attained.

Then, the plastic molded article having such a roughened surface is subjected to the catalyst addition step. A series of steps from the catalyst addition step to the electroless plating step are carried out in accordance with a conventionally known method. For example, in the catalyst addition step, the surface-roughened plastic molded article is immersed in a tin-palladium colloid catalyst solution for a several minutes. Then, to deposit metal palladium on the surface of the plastic molded article, activation treatment is carried out by use of acid such as hydrochloric acid or sulfuric acid. The activation treatment causes palladium to exhibit catalytic action, thereby allowing for electroless plating. For example, in electroless copper plating, the plastic molded article is immersed in an electroless plating solution (pH: 11.5) comprising 29 g/l of copper sulfate, 25 g/l of sodium carbonate, 140 g/l of tartrate, 40 g/l of sodium hydroxide and 150 ml of 37% formaldehyde. Thereby, copper ions are reduced by the reducing agent (formaldehyde) and deposited on the surface of the plastic molded article as metal copper. By the electroless plating treatment, a plating layer having a thickness of 0.5 to 1.0 µm is generally formed in 15 to 20 minutes.

### EFFECT OF THE INVENTION

As is clear from the above description and embodiment, by molding a thermoplastic material having specific shear strength, liquid-honing the surface of the plastic molded article by use of an alumina abrasive so as to attain specific surface roughness, and then carrying out addition of a catalyst, activation treatment and electroless plating in the order presented, a desired plating layer can be formed on the plastic molded article without impairing any properties of the thermoplastic material, and a product which retains excellent plating quality even when exposed to a sever environment and therefore maintains high reliability over a long time period can be provided. Therefore, plated plastic articles prepared by the production process of the present invention can be suitably used as electromagnetic shielding components for connectors for electric and electronic apparatuses, optical links for optical communication, electronic control units (ECU), boosters for discharge lamps and portable communication terminals, a variety of circuit boards, and plated ornamental parts.

### EXAMPLES

Examples of the present invention will be described hereinafter. The present invention shall not be limited to these examples as long as it is not deviated from the scope of the present invention.

In the examples, the surface roughness of a plastic molded article after liquid honing was determined in the following manner.

### [Surface Roughness]

The surface roughness of a roughened plastic molded article was measured by use of a commercial surface roughness meter in accordance with a method described in JIS B 0601. The measurement result was expressed as an average of surface roughnesses measured at 10 points (Rz, in µm).

Further, in the examples, adhesion of a plating layer was evaluated by use of the following method.

### (1) Measurement of Initial Peel Strength

On the plated surface of a test piece, two parallel incisions which reached a plastic base and had a width of 10 mm therebetween were made by use of a cutter knife, and one end of the plating layer portion between the incisions was peeled and raised about 15 to 25 mm from the base. Then, the peeled and raised end was attached to a tensile testing machine and pulled in a direction perpendicular to the plated surface at a cross head speed of 50 mm/min so as to measure peel strength (kgf/10 mm). A plating layer having a peel strength of lower than 0.5 kgf/10 mm is impractical.

### (2) Initial Adhesion (Cellophane Tape Peel Test)

A commercial cellophane tape was stuck on the plated portion of a test piece, and rubbed well with a finger so as to cause the tape to stick to the surface of the test piece securely. Then, one end of the cellophane tape was picked up with fingers and peeled at a stroke, and the condition of the underlying plated portion subjected to peeling was observed. The condition was evaluated based on the following evaluation criteria: ○ (Not Peeled), Δ (Somewhat Peeled), X (Significantly Peeled).

### (3) Heat Resistance Test

After left to stand in a hot air circulating vessel set at 100°C for 20 days, a test piece was taken out of the vessel. After the test piece was cooled to room temperature, the cellophane tape peel test described in (2) was carried out in the same manner, and the adhesion of a plating layer was evaluated.

### (4) Moisture Resistance Test

After left to stand in a constant-temperature-and-constant-humidity vessel set at 50°C and a relative humidity of 95% for 20 days, a test piece was taken out of the vessel. Then, after the test piece was left to stand at room temperature for one day, the cellophane tape peel test described in (2) was carried out in the same manner, and the adhesion of a plating layer was evaluated.

### (5) Thermal Shock Cycle Resistance Test

After a test piece was left to stand in a thermal shock cycle testing vessel set at the following conditions, it was taken out of the vessel upon completion of 100 cycles, and the cellophane tape peel test described in (2) was carried out in the same manner, and the adhesion of a plating layer was evaluated.
1 cycle: (100°C, 1 hour) → (23°C, relative humidity: 50%, 1 hour) → (-40°C, 1 hour) → (23°C, relative humidity: 50%, 1 hour)

### Example 1

A flat plastic molded article having a length of 10 cm, a width of 10 cm and a thickness of 3 mm was prepared by use of a non-reinforced polyacetal (shear strength: 53 MPa) and an injection molding machine. Thereafter, by use of a liquid honing machine, a molten alumina abrasive having a particle size of #100 was sprayed on a surface of the molded article at an injection pressure of 0.5 MPa for an injection time of 30 seconds so as to roughen the surface. Then, after the surface roughness of the roughened surface was measured in accordance with the above method, the molded article was rinsed with water, immersed in a tin-palladium colloid catalyst solution, and subjected to activation treatment using hydrochloric acid. Then, the molded article was immersed in an electroless copper plating solution for 25 minutes. The obtained electroless copper plating layer had a thickness of about 1.5 µm. Using a sample of the thus obtained electroless plating, evaluations of the above (2) to (5) were made. The results are shown in Table 1. Further, on some samples, an electrolytic copper plating layer having a thickness of about 30 µm was further formed after the electroless copper plating. Using the sample, the initial peel strength of the above (1) was measured. The result is also shown in Table 1.

### Example 2

An evaluation sample was obtained in the same manner as in Example 1 except that polybutylene terephthalate (shear strength = 65 MPa) containing 30% by weight of glass fibers was used, and evaluations were made in the same manner as in Example 1. The results are shown in Table 1.

### Example 3

An evaluation sample was obtained in the same manner as in Example 1 except that polyphenylene sulfide (shear strength = 88 MPa) containing 40% by weight of glass fibers and a molten alumina abrasive having a particle size of #220 were used, and evaluations were made in the same manner as in Example 1. The results are shown in Table 1.

### Example 4

An evaluation sample was obtained in the same manner as in Example 1 except that a wholly aromatic liquid crystal polyester (shear strength = 78 MPa) containing 40% by weight of glass fibers was used, and evaluations were made in the same manner as in Example 1. The results are shown in Table 1.

### Example 5

An evaluation sample was obtained in the same manner as in Example 1 except that 66 nylon (shear strength = 63 MPa) containing 20% by weight of glass fibers and a molten alumina abrasive having a particle size of #150 were used, and evaluations were made in the same manner as in Example 1. The results are shown in Table 1.

### Comparative Example 1

An evaluation sample was obtained in the same manner as in Example 1 except that polyacetal (shear strength = 27 MPa) containing 50% by weight of thermoplastic urethane was used, and evaluations were made in the same manner as in Example 1. The results are shown in Table 1.

### Comparative Example 2

An evaluation sample was obtained in the same manner as in Example 1 except that a non-reinforced polypropylene (shear strength = 40 MPa) was used, and evaluations were made in the same manner as in Example 1. The results are shown in Table 1.

### Comparative Example 3

An evaluation sample was obtained in the same manner as in Example 1 except that a non-reinforced 12 nylon (shear strength = 37 MPa) was used, and evaluations were made in the same manner as in Example 1. The results are shown in Table 1.

### Comparative Examples 4 to 7

Evaluation samples were obtained in the same manner as in Example 1 except that a non-reinforced polyacetal (shear strength = 53 MPa) (Comparative Example 4), polybutylene terephthalate (shear strength = 65 MPa) containing 30% by weight of glass fibers (Comparative Example 5), polyphenylene sulfide (shear strength = 88 MPa) containing 40% by weight of glass fibers (Comparative Example 6) and a wholly aromatic liquid crystal polyester (shear strength = 78 MPa) containing 40% by weight of glass fibers (Comparative Example 7) were used and that a molten alumina abrasive having a particle size of #360 was sprayed against surfaces of the molded articles at an injection pressure of 0.4 MPa for an injection time of 10 seconds so as to roughen the surfaces, and evaluations were made in the same manner as in Example 1. The results are shown in Table 1.

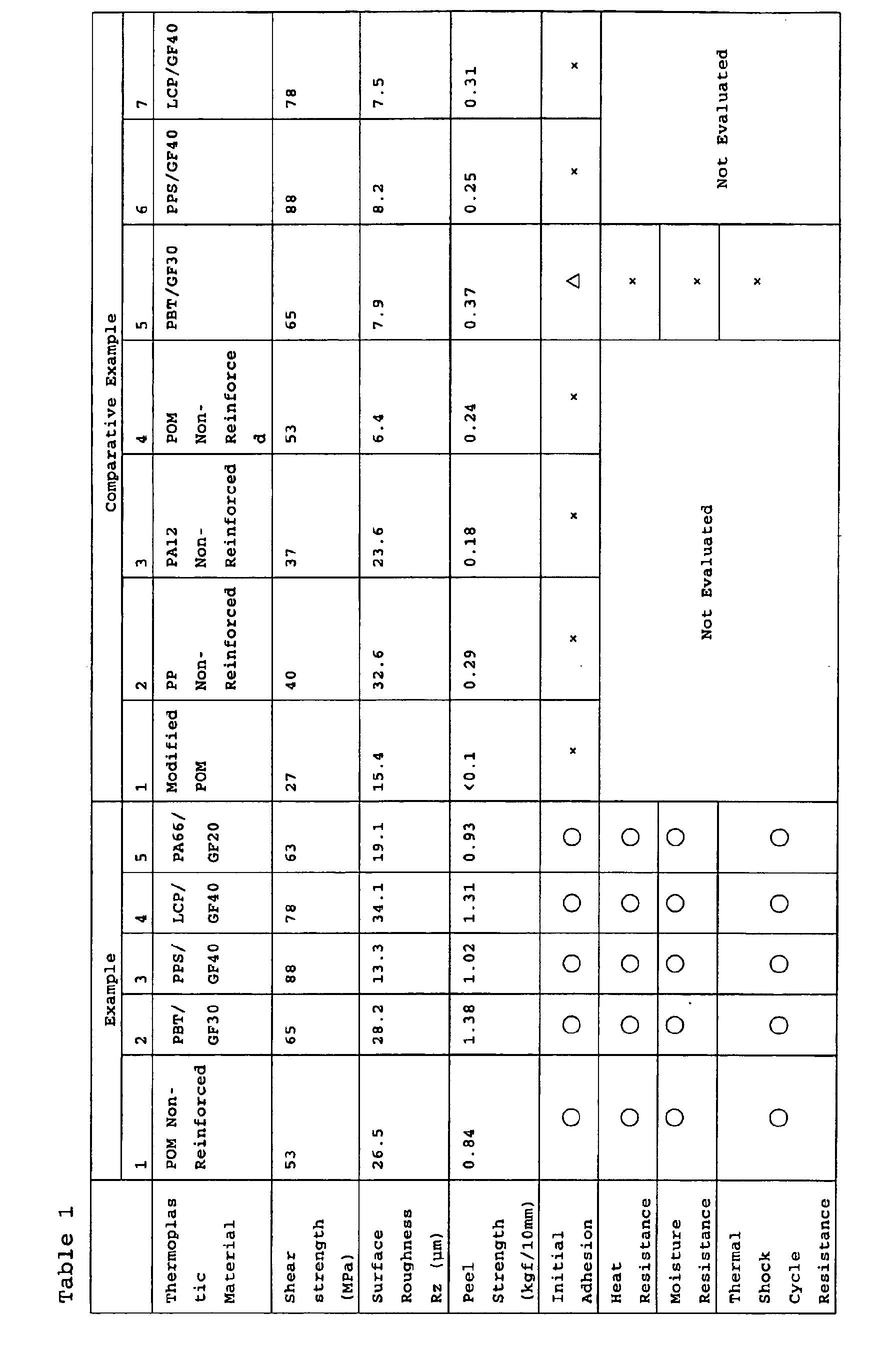

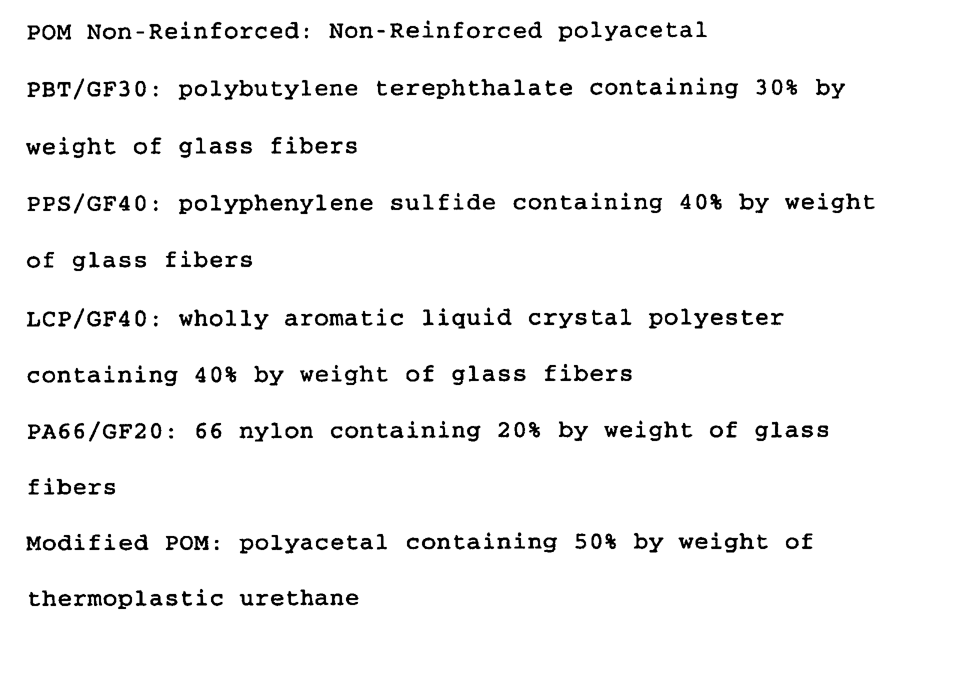

## Claims

1. A process for producing a plated plastic article, comprising the steps of molding a thermoplastic material having a shear strength of not lower than 50 MPa or higher, treating the surface of the molded article by liquid honing treatment with an aluminum abrasive so that the surface roughness Rz (average roughness of ten points) is at least 10 µm and subsequently adding a catalyst thereto, activating it and electroless-plating it.

2. The process as described in claim 1, wherein the thermoplastic material comprises, as the principal component, at least one resin selected from the group consisting of polyacetal, polybutylene terephthalate, polyphenylene sulfide, polyamide, liquid crystal polyester, polyimide and syndiotactic polystyrene.

3. The plated plastic article, prepared according to the process as described in claims 1 or 2, functioning practically as electric circuits.

4. The plated plastic article, prepared according to the process as described in claims 1 or 2 and having practically capability for electromagnetic shielding.

5. The article as described in claim 4, which is component parts of connectors for electrical and electronic apparatus, optical links for light communication, electronic control units (ECU), boosters for discharge lamps, or portable communication terminals and has practically capability for electromagnetic shielding.
